# EUROPEAN PATENT SPECIFICATION

(11) **EP 2 803 645 B1**
(45) Date of publication and mention of the grant of the patent: **01.08.2018**
(21) Application number: 13168335.1
(22) Date of filing: 17.05.2013
(51) Int. Cl.: C03C 3/066, C03C 8/02, C03C 17/34

(54) **Transparent diffusive oled substrate and method for producing such a substrate**
Transparentes OLED-Diffusionssubstrat und Verfahren zur Herstellung eines solchen Substrats
Substrat OLED diffusif transparent et procédé de fabrication d'un tel substrat

(43) Date of publication of application: 19.11.2014
(73) Proprietor: Saint-Gobain Glass France, 92400 Courbevoie (FR)
(72) Inventor: Lecamp, Guillaume, 75018 Paris (FR); Sauvinet, Vincent, 38000 Grenoble (FR); Youngseong, Lee, Yeomchang-dong Gangseo Seoul City (KR)
(74) Representative: Saint-Gobain Recherche

(56) References cited:
- EP-A1- 2 819 198
- WO-A1-2007/032977
- WO-A1-2012/133832
- WO-A1-2013/187735
- FR-A1- 2 963 705
- US-A1- 2004 156 110

## Description

The present invention is drawn to a new method for producing translucent, light-scattering substrates for organic light emitting diodes (OLED) and to substrates obtainable by such a method.

OLEDs are opto-electronic elements comprising a stack of organic layers with fluorescent or phosphorescent dyes sandwiched between two electrodes, at least one of which is translucent. When a voltage is applied to the electrodes the electrons injected from the cathode and the holes injected from the anode combine within the organic layers, resulting in light emission from the fluorescent/phosphorescent layers.

It is commonly known that light extraction from conventional OLEDs is rather poor, most of the light being trapped by total internal reflection in the high index organic layers and transparent conductive layers (TCL). Total internal reflection takes place not only at the boundary between the high index TCL and the underlying glass substrate (refractive index of about 1.5) but also at the boundary between the glass and the air.

According to estimates, in conventional OLEDs not comprising any additional extraction layer about 60 % of the light emitted from the organic layers is trapped at the TCL/glass boundary, an additional 20 % fraction is trapped at the glass/air surface and only about 20 % exit the OLED into air.

It is known to reduce this light entrapment by means of a light scattering layer between the TCL and the glass substrate. Such light scattering layers have a high refractive index close to the TCL index and contain a plurality of light diffusing elements.

It is also known to increase out-coupling of light by texturing the interface between the glass and the high index layers of the OLED.

Both of these "internal" extraction means, also commonly called "internal extraction layers" (IEL), comprise asperities that need to be planarized before applying the TCL and the organic stack.

WO2011/089343 discloses OLED substrates comprising at least one textured surface planarized with a high index glass coating. The substrates are described as being texturized by acid etching. Glass etching using strong acids, in particular HF, is a commonly used method for texturizing glass surfaces. Such a wet chemistry method however is a complicated process when carried out on thin glass (thickness <1 mm). This technique allows only for one of the two faces to be etched per process step as the glass plate has to be kept in a horizontal position during the etching step. Furthermore the roughness profile parameters are difficult to optimize and above all the use of HF results in important security problems for the environment and persons working nearby.

The applicant has recently developed an interesting alternative method for roughening one or both sides of the glass substrate, said method comprising mechanical roughening (lapping). This method, described in European application 12306179.8 filed on September 28, 2012, is much less hazardous than chemical etching, allows for better control of the roughness profile and makes it possible to simultaneously roughen both sides of the substrates, thereby producing in a single process step the internal and external extraction layers (IEL and EEL) of a transparent OLED glass substrate.

WO 2012/133832 A1, WO2013187735 A1 and EP2819198 A1 also disclose substrates for OLEDs containing light extraction layers. The present invention is drawn to still another method for producing diffusive low index glass substrates, said method comprising neither a chemical etching step nor a mechanical abrasion step. The idea underlying the present invention is to bond low index mineral particles by means of a low index mineral binder to a low index glass substrate, the amount of mineral binder with respect to the mineral particles being sufficiently low so that the mineral particles protrude from the binder surface or, at least, create significant roughness at the mineral binder surface.

The diffusive low index substrate thus obtained is then submitted to a commonly known planarization step using a high index frit, and the resulting planarized diffusive substrate may then be coated with a transparent conductive layer (TCL) and be used as a light-extraction substrate for OLEDs.

The method of the present invention is easy to implement, requiring only rather simple and commonly known equipment. One significant advantage over the lapping method described in EP 12306179.8 is that it may be used for very large surfaces. Additionally, the lapping method slightly decreases the substrate's mechanical resistance, which is not the case for the method of the present invention.

The first subject-matter of the present invention is a transparent diffusive OLED substrate comprising the following successive elements or layers:
(a) a transparent flat substrate made of mineral glass having a refractive index of between 1.45 and 1.65,
(b) a rough low index layer comprising mineral particles, said mineral particles being bonded to one side of the substrate by means of a low index enamel, the mineral particles near, at or protruding from the enamel's surface creating a surface roughness characterized by an arithmetical mean deviation Rₐ comprised between 0.15 and 3 µm, the mineral particles and low index enamel both having a refractive index of between 1.45 and 1.65, the volume ratio of the mineral particles to the low index enamel being comprised between 0.3 and 3;
(c) a high index planarization layer made of an enamel having a refractive index comprised between 1,8 and 2,1 covering the rough low index layer (b).

The present invention also provides a method for preparing a diffusive substrate as defined above.

The low index layer of the OLED substrate of the present invention is defined by its refractive index (1.45 - 1.65) and by its surface roughness profile, i.e. an arithmetical mean deviation Rₐ (such as defined in ISO 4287) comprised between 0.15 and 3 µm, said roughness being created by the mineral particles near, at or protruding from the low index enamel's surface. The mineral particles do not necessarily need to protrude from the low index enamel but may be embedded therein as long as it is apparent, for example from a sectional SEM view, that the roughness or waviness of the low index mineral layer can be attributed to the underlying particles, the surface profile closely matching the presence/absence of embedded mineral particles.

The mineral particles used in the present invention may be crystalline, amorphous or semi-crystalline particles. They may have a random shape with more or less sharp edges but preferably are rather spherical particles free of sharp edges.

In a preferred embodiment, the mineral particles are solid beads. Such beads are preferred over randomly-shaped sharp-edged particles because they easily spread over the substrate's surface thereby facilitating formation of a thin monolayer of beads, rather than large sized aggregates. Sphere-like particles devoid of sharp edges are also more easily planarized than randomly shaped particles. It is to be understood that hollow beads are not encompassed in the definition of mineral particles of the present invention, because the gas contained therein has a refractive index not comprised between 1.45 and 1.65.

The term "mineral particle", especially when used to describe the method of the present invention, encompasses particles functionalized with organic surface groups, such as trialkylsilyl groups. Said organic surface groups undergo thermal decomposition during the baking or fusing step of the mineral binder or, at the latest, during the formation of the high index enamel layer and consequently are no longer present in the final product.

The mineral particles used in the present invention, whether spherical or not, have an average equivalent spherical diameter (measured by DLS) of between 0.3 µm and 10 µm, preferably of between 0.5 µm and 8 µm, more preferably of between 0.8 µm and 7 µm, the equivalent spherical diameter of the irregularly shaped particles being defined as the diameter of the sphere having the same volume as the mineral particle.

The average equivalent spherical diameter however is not the only size parameter to consider for selecting the mineral particles to be used in the present invention. Advantageously, the mineral particles are essentially free of large sized particles, which would protrude not only from the mineral binder but also from the high index enamel layer, which would then lead to current leakage in the final OLED. The mineral particles used in the present invention consequently are preferably essentially devoid of particles having an equivalent spherical diameter higher than 15 µm, preferably higher than 12 µm.

As already specified above, the glass substrate, the mineral particles and the mineral binder, i.e. the low index enamel, all have about the same refractive index, comprised between 1.45 and 1.65, preferably between 1.50 and 1.60.

In a preferred embodiment of the present invention, the mineral particles are selected from silica particles.

In order to obtain diffusive substrates from ingredients all having about the same refractive index, it is necessary to create and control the surface roughness of the low index mineral layer. As mentioned above, the low index mineral layer should have an arithmetical mean deviation Rₐ comprised between 0.15 and 3 µm, preferably between 0.2 and 2 µm.

The arithmetical mean deviation Rₐ is defined in ISO 4287. It may be measured by scanning electron microscopy (SEM) of cross sections of the sample, by surface profile measurement or by 3D laser microscopy.

To obtain a mineral low index layer having both a suitable surface roughness and a satisfactory mechanical resistance, it is important to appropriately select the amount of low index glass frit with respect to the amount of mineral particles. If one uses too high amounts of glass frit, the mineral particles will be completely embedded in the resulting low index mineral binder matrix and will not create the required surface roughness (Rₐ) of between 0.15 and 3 µm. On the other hand, in case the amount of mineral binder is too low with respect to the mineral particles, the bonding strength of the enamel binder is too weak and the resulting mineral layer will be excessively brittle and easily damaged when handled.

The applicant found that a weight ratio of mineral particles to the glass frit comprised between 0.2 and 4, preferably between 0.4 and 3, leads to a suitable surface roughness and mechanical resistance of the low index layer.

The final low index mineral layer is characterized by the volume ratio of the mineral particles to the low index enamel which is comprised between 0.3 and 3, preferably between 0.5 and 2 and more preferably between 0.7 and 1.5.

The high index enamel (c) on the low index mineral layer (b) should be thick enough to completely cover and planarize the roughness profile thereof.

The thickness of the high index layer is advantageously comprised between 3 µm and 20 µm, preferably between 4 µm and 15 µm and more preferably between 5 µm and 12 µm. The thickness of the high index layer is the mean distance between the mean lines (defined as in ISO 4287, 3.1.8.1) of the roughness profile of the low index layer and the roughness profile of the high index layer.

The surface roughness of the high index layer should be preferably as low as possible and the high index enamel advantageously has an arithmetical mean deviation Rₐ of less than 3 nm, more preferably less than 2 nm and most preferably less than 1 nm.

The high index layer is preferably essentially free of diffusive elements dispersed therein, especially free of diffusive solid particles dispersed therein. As a matter of fact such solid diffusive particles could undesirably protrude from the surface of the high index layer and cause leakage currents in the final OLED.

The resulting flat glass substrate carrying the low index mineral layer (low index mineral particles + low index enamel) planarized by the high index glass frit generally has a haze comprised between 75 and 98 %, preferably between 85 and 97 %, and more preferably between 87 and 95 %. Haze value can be measured by optical spectrophotometers like PE Lambda 950 or Varian Carry 5000, but also by faster and cheaper dedicated devices like BYK Hazemeter.

In a preferred embodiment, the transparent diffusive OLED substrate of the present invention further comprises a transparent electro-conductive layer (d) preferably directly in contact with the high index enamel layer (c). Such transparent conductive layers that may be used as anodes for OLEDs are well known in the prior art. The most commonly material used is ITO (Indium Tin Oxide). The transparent conductive layer should have a light transmission of at least 80 %, and a refractive index (at λ = 550 nm) of between 1.7 and 2.2. Its total thickness is typically comprised between 50 and 400 nm.

As mentioned above the present invention is also drawn to a method for preparing the OLED substrate of the present invention, said method comprising the following successive steps:
(1) Providing a transparent flat substrate made of mineral glass having a refractive index of between 1,45 and 1,65;
(2) Applying onto one side of said substrate a low index glass frit mixed with mineral particles having a glass transition temperature (T_{g}) or a fusion temperature at least 50 °C higher than the T_{g} of the glass frit, both the glass frit and the mineral particles having a refractive index of between 1.45 and 1.65, the volume ratio of the mineral particles to the low index enamel being comprised between 0.3 and 3;
(3) Heating the resulting glass frit layer to a temperature allowing fusion of the glass frit without fusion of the mineral particles, resulting in an rough low index layer comprising mineral particles bonded to the substrate by means of a low index enamel;
(4) Applying onto said rough low index layer a layer of a high index glass frit having a refractive index of between 1.8 and 2.1;
(5) Drying and fusing said high index glass frit so as to obtain a high index enamel having a refractive index comprised between 1.8 and 2.1 covering the transparent rough low index layer.

The flat glass substrates provided at step (1) advantageously have a thickness of between 0.1 and 5 mm, preferably of between 0.3 and 1.6 mm.

At step (2) the glass frit particles and mineral particles are mixed and suspended in a conventional organic vehicle comprising an organic solvent and an organic polymer. The suspension is then applied according to known techniques such as screen printing or slot coating. The mineral particles may be amorphous, crystalline or semi-crystalline. They should not fuse or be substantially softened during the subsequent fusion step (4) of the glass frit. That's why the fusion point of the crystalline particles or the T_{g} of the amorphous fraction of the particles must be significantly higher than the T_{g} of the glass frit, i.e. at least 50 °C, more preferably at least 100 °C higher than the T_{g} of the glass frit.

Low index glass frits that may be used in the present invention for bonding the mineral particles to the glass substrates are well known in the art.

Preferred low index glass frits have the following composition:
SiO₂: 10 - 40 wt%
Al₂O₃: 1 - 7 wt%
B₂O₃: 20 - 50 wt%
Na₂O+Li₂O+K₂O: 5-30 wt%
ZnO: 3 - 35 wt%

At step (3) the frit-coated substrate is submitted to firing at a temperature sufficiently high to effect fusion of the glass frit. To obtain complete fusion of the glass frit, it is generally necessary to heat the substrate to a temperature at least 100 °C higher than the T_{g} of the glass frit and to maintain this temperature for a duration of about 2 to 30 min.

In a typical embodiment, the glass frit and mineral particles (70 - 80 wt%) are mixed with 20 - 30 wt% of an organic vehicle (ethyl cellulose and organic solvent). The resulting paste is then applied onto the glass substrate for example by screen-printing or slot-coating. The resulting layer is dried by heating at a temperature of 120 - 200 °C. The organic binder (ethyl cellulose) is burned out at a temperature of between 350 - 440 °C, and the firing step resulting in the final enamel is carried out at a temperature of between 510 °C and 610 °C, preferably between 520 °C and 600 °C.

At step (4) the high index glass frit is then applied onto the low index rough layer by any suitable method such as screen printing, spray coating, bar coating, roll coating, slot coating and spin coating, of an aqueous or organic suspension of glass particles. A description of suitable high index glass frits and methods for coating and firing them can be found for example in EP 2 178 343.

The glass frit should be selected to have a melting point comprised between 450 °C and 570 °C and should lead to an enamel having a refractive index of 1.8 to 2.2.

Preferred high index glass frits have the following composition:
Bi₂O₃: 55 - 75 wt%
BaO: 0 - 20 wt%
ZnO: 0 - 20 wt%
Al₂O₃: 1 - 7 wt%
SiO₂: 5 - 15 wt%
B₂O₃: 5 - 20 wt%
Na₂O: 0.1 - 1 wt%
CeO₂: 0 - 0.1 wt%

In a typical embodiment, the glass frit particles (70 - 80 wt%) are mixed with 20 - 30 wt% of an organic vehicle (ethyl cellulose and organic solvent). The resulting frit paste is then applied onto the diffusive coated glass substrate by screen printing or slot coating. The resulting layer is dried by heating at a temperature of 120 - 200 °C. The organic binder (ethyl cellulose) is burned out at a temperature of between 350 - 440 °C, and the firing step resulting in the final enamel is carried out at a temperature of between 510 °C and 610, preferably between 520 °C and 600 °C.

The resulting enamels have been shown to have a surface roughness with an arithmetical mean deviation Rₐ (ISO 4287) of less than 3 nm when measured by AFM on an area of 10 µm x 10 µm.

The amount of the high index glass frit coated onto the roughened surface is generally comprised between 20 and 200 g/m², preferably between 25 and 150 g/m², more preferably between 30 and 100 g/m², and most preferably between 35 and 70 g/m².

The high index glass frit used in the present invention and the enamel resulting therefrom preferably are substantially devoid of solid scattering particles such as crystalline SiO₂ or TiO₂ particles. Such particles are commonly used as scattering elements in high index scattering layers but generally require an additional planarization layer, thereby increasing the total thickness of the high index coating.

The diffusive substrates planarized with high index enamel are particularly useful as substrates for bottom-emitting OLEDs. A transparent conductive layer has to be applied on top of the high index enamel before application of the stack of organic light emitting layers.

In a preferred embodiment, the method of the present invention therefore further comprises an additional step of coating the high index enamel resulting from step with a transparent conductive layer, preferably a transparent conductive oxide. Formation of such a TCL may be carried out according to conventional methods such as magnetron sputtering.

### Example 1

A low index frit (20 parts by weight) is mixed with spherical SiO₂ particles (10 parts by weight) having an average equivalent diameter of 6 µm. The resulting powder is dispersed in 70 parts by weight of an organic medium using a 3-roll milling process.

The low index frit used has the following composition: 28.4 wt% of SiO₂; 3.6 wt% of Al₂O₃; 39.5 wt% of B₂O₃; 15.9 wt% of alkali oxides (Na₂O, Li₂O, K₂O); 12.6 wt% of ZnO. It has a refractive index of 1.54 and a T_{g} of 484 °C.

The resulting slurry is coated by screen-printing on a soda-lime glass substrate (0.7 mm) and then submitted to drying at 150 °C. The dried coating is fired at 600 °C for 20 minutes in an IR furnace.

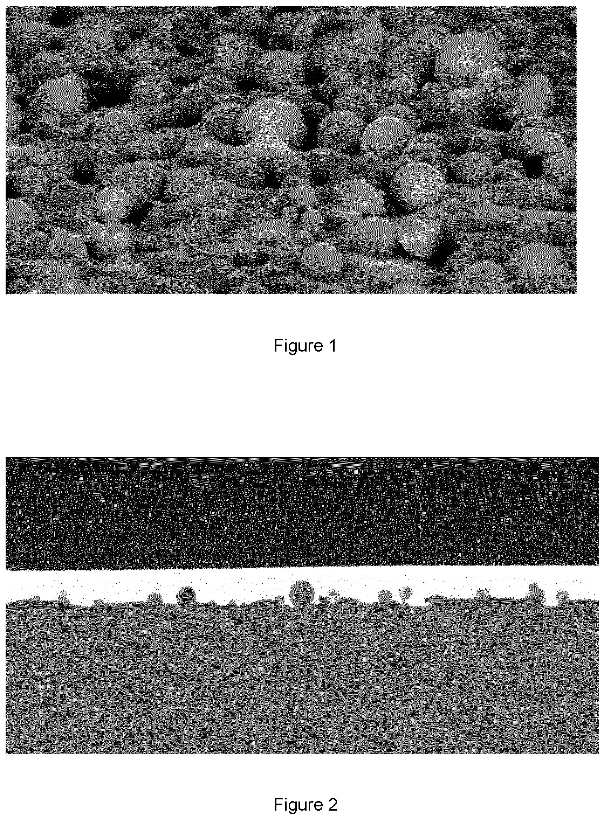

Figure 1 shows the SEM micrograph of the rough low index layer after firing and before planarization with the high index frit.

The resulting low index rough layer was then coated by screen-printing with a slurry of a high index frit having a refractive index of 1.90.

The coating was dried at 150 °C and was submitted to firing for 10 minutes at 545°C in an IR furnace.

Figure 2 shows the SEM micrograph of the planarized substrate (glass substrate carrying mineral particles bonded by low index enamel in grey; high index planarization layer in white).

## Claims

1. A transparent diffusive OLED substrate comprising the following successive elements or layers :
(a) a transparent flat substrate made of mineral glass having a refractive index of between 1.45 and 1 .65,
(b) a rough low index layer comprising mineral particles, said mineral particles being bonded to one side of the substrate by means of a low index enamel, the mineral particles near, at or protruding from the enamel's surface creating a surface roughness **characterized by** an arithmetical mean deviation Rₐ comprised between 0.15 and 3 µm, the mineral particles and enamel both having a refractive index of between 1.45 and 1.65, the volume ratio of the mineral particles to the low index enamel being comprised between 0.3 and 3;
(c) a high index planarization layer made of an enamel having a refractive index comprised between 1,8 and 2,1 covering the rough low index layer (b).

2. The substrate according to claim 1, wherein the mineral particles have an average equivalent spherical diameter of between 0.3 µm and 10 µm, preferably of between 0.5 µm and 8 µm, more preferably of between 0.8 µm and 7 µm.

3. The substrate according to claim 1 or 2, wherein the mineral particles are solid beads.

4. The substrate according to any of the preceding claims, wherein the mineral particles are essentially free of particles having an equivalent spherical diameter higher than 15 µm, preferably higher than 12 µm and more preferably higher than 10 µm.

5. The substrate according to any of the preceding claims, wherein the refractive index of the substrate, low index enamel and mineral particles is comprised between 1.50 and 1.60.

6. The substrate according to any of the preceding claims, wherein the thickness of the high index layer is comprised between 3 µm and 20 µm, preferably between 4 µm and 15 µm and more preferably between 5 µm and 12 µm.

7. The substrate according to any of the preceding claims, wherein the surface roughness of the high index layer has an arithmetical mean deviation Rₐ of less than 3 nm, more preferably less than 2 nm and most preferably less than 1 nm.

8. The substrate according to any of the preceding claims, wherein the high index layer is essentially free of diffusive elements dispersed therein, especially free of diffusive solid particles dispersed therein.

9. The substrate according to any of the preceding claims, wherein the mineral particles are selected from silica particles.

10. The substrate according to any of the preceding claims further comprising a transparent electro-conductive layer on the high index enamel layer.

11. The substrate according to any of the preceding claims, wherein the volume ratio of the mineral particles to the low index enamel is comprised between between 0.5 and 2, preferably between 0.7 and 1.5.

12. A method for preparing a transparent diffusive substrate according to any of claims 1 - 11, comprising the following steps :
(1) Providing a transparent flat substrate made of mineral glass having a refractive index of between 1,45 and 1,65;
(2) Applying onto one side of said substrate a low index glass frit mixed with mineral particles having a glass transition temperature (T_{g}) or a fusion temperature at least 50 °C higher than the T_{g} of the glass frit, both the glass frit and the mineral particles having a refractive index of between 1.45 and 1.65;
(3) Heating the resulting glass frit layer to a temperature allowing fusion of the glass frit without fusion of the mineral particles, resulting in an rough low index layer comprising mineral particles bonded to the substrate by means of a low index enamel, the volume ratio of the mineral particles to the low index enamel being comprised between 0.3 and 3;
(4) Applying onto said rough low index layer a layer of a high index glass frit having a refractive index of between 1.8 and 2.1;
(5) Drying and fusing said high index glass frit so as to obtain a high index enamel having a refractive index comprised between 1.8 and 2.1 covering the transparent rough low index layer.

13. The method according to claim 12, wherein the mineral particles have an average equivalent spherical diameter of between 0.3 µm and 10 µm, preferably of between 0.5 µm and 8 µm, more preferably of between 0.8 µm and 7 µm

14. The method according to claim 12 or 13, wherein the weight ratio of the mineral particles to the glass frit is comprised between 0.2 and 4, preferably between 0.4 and 3.

15. The method according to any of claims 12 to 14, wherein the fusing of the high index glass frit is carried out at a temperature comprised between 510 °C and 580 °C, preferably between 520 °C and 580 °C.

## Patentansprüche

1. Transparentes diffundierendes OLED-Substrat, umfassend die folgenden aufeinanderfolgenden Elemente oder Schichten:
(a) ein transparentes flaches Substrat aus Mineralglas mit einem Brechungsindex zwischen 1,45 und 1,65,
(b) eine grobe Schicht mit niedrigem Index, die Mineralteilchen umfasst, wobei die Mineralteilchen mittels eines Emails mit niedrigem Index an eine Seite des Substrats gebunden sind, wobei die Mineralteilchen, die in der Nähe der Emailoberfläche, an dieser oder von dieser vorstehend sind, eine Oberflächenrauigkeit schaffen, die durch eine arithmetische Mittelabweichung Rₐ zwischen 0,15 und 3 µm gekennzeichnet ist, wobei die Mineralteilchen und das Email beide einen Brechungsindex zwischen 1,45 und 1,65 aufweisen, wobei das Volumenverhältnis der Mineralteilchen zu dem Email mit niedrigem Index zwischen 0,3 und 3 liegt;
(c) eine Ebnungsschicht mit hohem Index aus einem Email mit einem Brechungsindex, der zwischen 1,8 und 2,1 liegt, der die raue Schicht mit niedrigem Index (b) bedeckt.

2. Substrat nach Anspruch 1, wobei die Mineralteilchen einen durchschnittlichen äquivalenten Kugeldurchmesser zwischen 0,3 µm und 10 µm, vorzugsweise zwischen 0,5 µm und 8 µm, stärker bevorzugt zwischen 0,8 µm und 7 µm, aufweisen.

3. Substrat nach Anspruch 1 oder 2, wobei die Mineralteilchen feste Kügelchen sind.

4. Substrat nach einem der vorstehenden Ansprüche, wobei die Mineralteilchen im Wesentlichen frei von Teilchen mit einem äquivalenten Kugeldurchmesser von mehr als 15 µm, vorzugsweise mehr als 12 µm und stärker bevorzugt mehr als 10 µm, sind.

5. Substrat nach einem der vorstehenden Ansprüche, wobei der Brechungsindex des Substrats, des Emails mit niedrigem Index und der Mineralteilchen zwischen 1,50 und 1,60 liegt.

6. Substrat nach einem der vorstehenden Ansprüche, wobei die Dicke der Schicht mit hohem Index zwischen 3 µm und 20 µm, vorzugsweise zwischen 4 µm und 15 µm und stärker bevorzugt zwischen 5 µm und 12 µm, liegt.

7. Substrat nach einem der vorstehenden Ansprüche, wobei die Oberflächenrauigkeit der Schicht mit hohem Index eine arithmetische Mittelabweichung Rₐ von weniger als 3 nm, stärker bevorzugt weniger als 2 nm und am stärksten bevorzugt weniger als 1 nm, aufweist.

8. Substrat nach einem der vorstehenden Ansprüche, wobei die Schicht mit hohem Index im Wesentlichen frei von darin dispergierten diffundierenden Elementen ist, insbesondere frei von darin dispergierten diffundierenden festen Teilchen.

9. Substrat nach einem der vorstehenden Ansprüche, wobei die Mineralteilchen aus Siliziumdioxidteilchen ausgewählt sind.

10. Substrat nach einem der vorstehenden Ansprüche, ferner umfassend eine transparente elektrisch leitende Schicht auf der Emailschicht mit hohem Index.

11. Substrat nach einem der vorstehenden Ansprüche, wobei das Volumenverhältnis der Mineralteilchen zu dem Email mit niedrigem Index zwischen 0,5 und 2, vorzugsweise zwischen 0,7 und 1,5, liegt.

12. Verfahren zur Herstellung eines transparenten diffundierenden Substrats nach einem der Ansprüche 1 bis 11, umfassend die folgenden Schritte:
(1) Bereitstellen eines transparenten flachen Substrats aus Mineralglas mit einem Brechungsindex zwischen 1,45 und 1,65;
(2) Aufbringen einer Glasfritte mit niedrigem Index, die mit Mineralteilchen mit einer Glasübergangstemperatur (T_{g}) oder einer Schmelztemperatur, die mindestens 50 °C höher ist als die T_{g} der Glasfritte, gemischt ist, auf eine Seite des Substrats, wobei sowohl die Glasfritte als auch die Mineralteilchen einen Brechungsindex zwischen 1,45 und 1,65 aufweisen;
(3) Erhitzen der resultierenden Glasfrittenschicht auf eine Temperatur, die ein Schmelzen der Glasfritte ohne Schmelzen der Mineralteilchen ermöglicht, was zu einer rauen Schicht mit niedrigem Index führt, die Mineralteilchen umfasst, die mittels eines Emails mit niedrigem Index an das Substrat gebunden sind, wobei das Volumenverhältnis der Mineralteilchen zu dem Email mit niedrigem Index zwischen 0,3 und 3 liegt;
(4) Aufbringen einer Schicht einer Glasfritte mit hohem Index, die einen Brechungsindex zwischen 1,8 und 2,1 aufweist, auf die raue Schicht mit niedrigem Index;
(5) Trocknen und Schmelzen der Glasfritte mit hohem Index, um ein Email mit hohem Index zu erhalten, das einen Brechungsindex zwischen 1,8 und 2,1 aufweist, das die transparente raue Schicht mit niedrigem Index bedeckt.

13. Verfahren nach Anspruch 12, wobei die Mineralteilchen einen durchschnittlichen äquivalenten Kugeldurchmesser zwischen 0,3 µm und 10 µm, vorzugsweise zwischen 0,5 µm und 8 µm, stärker bevorzugt zwischen 0,8 µm und 7 µm, aufweisen.

14. Verfahren nach Anspruch 12 oder 13, wobei das Gewichtsverhältnis der Mineralteilchen zu der Glasfritte zwischen 0,2 und 4, vorzugsweise zwischen 0,4 und 3, liegt.

15. Verfahren nach einem der Ansprüche 12 bis 14, wobei das Schmelzen der Glasfritte mit hohem Index bei einer Temperatur zwischen 510 °C und 580 °C, vorzugsweise zwischen 520 °C und 580 °C, durchgeführt wird.

## Revendications

1. Substrat transparent diffusant pour OLED, comprenant les éléments successifs suivants ou couches successives suivantes :
(a) Un substrat plat transparent (1) en verre minéral ayant un indice de réfraction compris entre 1,45 et 1,65,
(b) Une couche rugueuse de bas indice comprenant des particules minérales, lesdites particules minérales étant liées à une face du substrat au moyen d'un émail bas indice, les particules minérales proches de la surface, au niveau de la surface ou faisant saillie à partir de la surface créant une rugosité de surface **caractérisée par** une écart moyen arithmétique Ra compris entre 0,15 et 3 µm, les particules minérales et le liant minéral ayant un indice de réfraction compris entre 1,45 et 1,65, le rapport volumique des particules minérales à l'émail bas indice étant compris entre 0,3 et 3,
(c) Une couche à haut indice faite en un émail ayant un indice de réfraction compris entre 1,8 et 2,1, recouvrant la couche rugueuse de bas indice (b).

2. Substrat selon la revendication 1, dans lequel les particules minérales ont un diamètre sphérique équivalent moyen compris entre 0,3 µm et 10 µm, de préférence entre 0,5 µm et 8 µm, et plus préférentiellement entre 0,8 et 7 µm.

3. Substrat selon la revendication 1 ou 2, dans lequel les particules minérales sont des billes pleines.

4. Substrat selon l'une quelconque des revendications précédentes, dans lequel les particules minérales sont essentiellement exemptes de particules ayant un diamètre sphérique équivalent supérieur à 15 µm, de préférence supérieur à 12 µm et plus préférentiellement supérieur à 10 µm.

5. Substrat selon l'une quelconque des revendications précédentes, dans lequel l'indice de réfraction du substrat, de l'émail bas indice et des particules minérales est compris entre 1,50 et 1,60.

6. Substrat selon l'une quelconque des revendications précédentes, dans lequel l'épaisseur de la couche à haut indice est compris entre 3 µm et 20 µm, de préférence entre 4 µm et 15 µm, et plus préférentiellement entre 5 µm et 12 µm.

7. Substrat selon l'une quelconque des revendications précédentes, dans lequel la rugosité de surface de la couche à haut indice a un écart moyen arithmétique Ra inférieur à 3 nm, de préférence inférieur à 2 nm et plus préférentiellement inférieur à 1 nm.

8. Substrat selon l'une quelconque des revendications précédentes, dans lequel la couche à haut indice est essentiellement exempte d'éléments diffusants dispersés dans celle-ci, en particulier exempte de particules pleines dispersées.

9. Substrat selon l'une quelconque des revendications précédentes, dans lequel les particules minérales sont choisies parmi les particules de silice.

10. Substrat selon l'une quelconque des revendications précédentes, comprenant en outre une couche électroconductrice transparente sur la couche d'émail à haut indice.

11. Substrat selon l'une quelconque des revendications précédentes, dans lequel le rapport volumique des particules minérales au liant minéral est compris entre 0,5 et 2, de préférence entre 0,7 et 1,5.

12. Procédé de préparation d'un substrat transparent diffusant selon l'une quelconque des revendications précédentes, comprenant les étapes successives suivantes :
(1) Mise à disposition d'un substrat plat transparent en verre minéral ayant un indice de réfraction compris entre 1,45 et 1,65 ;
(2) Application sur une face dudit substrat d'une fritte de verre bas indice mélangée à des particules minérales ayant une température de transition vitreuse (Tg) ou de fusion supérieure d'au moins 50 °C que la Tg de la fritte de verre, la fritte et de verre et les particules minérales ayant un indice de réfraction compris entre 1,45 et 1,65;
(3) Chauffage de la couche de fritte de verre formée à une température permettant de fondre la fritte de verre sans faire fondre les particules minérales, de manière à former une couche rugueuse de bas indice comprenant des particules minérales liées au substrat au moyen de l'émail bas indice, le rapport volumique des particules minérales à l'émail bas indice étant compris entre 0,3 et 3;
(4) Application d'une fritte de verre haut indice présentant un indice de réfraction compris entre 1,8 et 2,1 sur ladite couche rugueuse de bas indice ;
(5) Séchage et fusion de ladite fritte de verre de manière à former une couche d'émail à haut indice présentant un indice de réfraction compris entre 1,8 et 2,1 et couvrant la couche rugueuse bas indice.

13. Procédé selon l'une quelconque des revendications 12 à 14, dans lequel les particules minérales ont un diamètre sphérique équivalent moyen compris entre 0,3 µm et 10 µm, de préférence entre 0,5 µm et 8 µm et plus préférentiellement entre 0,8 µm et 7 µm.

14. Procédé selon la revendication 12 ou 13, dans lequel le rapport en poids des particules minérales à la fritte de verre est compris entre 0,2 et 4, de préférence entre 0,4 et 3.

15. Procédé selon l'une quelconque des revendications 12 à 14, dans lequel la fusion de la fritte de verre à haut indice est mise en oeuvre à une température comprise entre 510 °C et 580 °C, de préférence entre 520 °C et 580 °C.
